# EUROPEAN PATENT APPLICATION

(11) **EP 4 572 007 A1**
(43) Date of publication of application: **18.06.2025**
(21) Application number: 24215426.8
(22) Date of filing: 26.11.2024
(51) Int. Cl.: H01Q 1/22, H01Q 13/02

(54) **ELECTRONIC DEVICES WITH ANTENNAS AND RF REFLECTORS AND METHODS OF FABRICATING SUCH DEVICES**

(30) Priority: 13.12.2023 US 202318537855
(71) Applicant: NXP USA, Inc., Austin, TX 78735 (US)
(72) Inventor: Vincent, Michael B, 5656AG Eindhoven (NL)
(74) Representative: Hardingham, Christopher Mark

(57) **Abstract**

An electronic device includes a routing structure, an electronic circuit, an antenna, and an RF reflector. The electronic circuit is coupled to a mounting surface of the routing structure above a circuit zone. The antenna is coupled to the routing structure in an antenna zone. The RF reflector is coupled to the mounting surface above a reflector zone. The RF reflector includes an inner boundary portion that is adjacent to the antenna zone, and a circuit-adjacent segment positioned between the inner boundary portion and the electronic circuit. At least part of an upper extent of the inner boundary portion is at a first height above the mounting surface. An upper extent of the circuit-adjacent segment is at a second height above the mounting surface that is greater than the first height. The routing structure may be a printed circuit board or a redistribution layer structure.

## Description

### TECHNICAL FIELD

Embodiments of the subject matter described herein relate generally to electronic devices that include antennas.

### BACKGROUND

Various types of electronic systems include antennas that radiate and receive electromagnetic signals over the air. Some systems include electronic devices that include antennas and circuitry within a same device package. When antennas and circuitry are integrated within the same package, it is important to design the device so that electromagnetic signal interference associated with the antenna does not detrimentally affect the performance and proper functioning of the circuitry. Electromagnetic signal interference also may affect the performance and proper functioning of other circuitry and antennas outside of the device package, as well. Accordingly, system designers continue to develop structures and methods that make electronic systems less prone to performance degradation due to interfering electromagnetic radiation.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a side, cross-sectional view of an electronic device that includes an in-package antenna, an electronic circuit, and a radio frequency (RF) reflector, in accordance with an example embodiment;
FIG. 2 is a top view of the electronic device of FIG. 1, in accordance with an example embodiment;
FIG. 3 is a top view of the electronic device of FIG. 1, in accordance with another example embodiment;
FIG. 4 is a side, cross-sectional view of another embodiment of an electronic device that includes an in-package antenna, an electronic circuit, and a radio frequency (RF) reflector;
FIG. 5 is a top view of the electronic device of FIG. 4, in accordance with an example embodiment;
FIG. 6 is a top view of the electronic device of FIG. 4, in accordance with another example embodiment;
FIG. 7 is a side, cross-sectional view of yet another embodiment of an electronic device that includes an in-package antenna, an electronic circuit, and an RF reflector;
FIG. 8 is a side, cross-sectional view of yet another embodiment of an electronic device that includes an in-package antenna, an electronic circuit, and an RF reflector;
FIG. 9 is a top view of the electronic device of FIG. 7 or of FIG. 8, in accordance with an example embodiment;
FIG. 10 is a flowchart of a method for fabricating the electronic device embodiments of FIGs 1-6, in accordance with an example embodiment;
FIG. 11 is a flowchart of a method for fabricating the electronic device embodiments of FIGs 7-9, in accordance with an example embodiment; and
FIG. 12 is a flowchart of a method for fabricating the electronic device embodiments of FIGs 1-6 and 8, in accordance with other example embodiments.

### DETAILED DESCRIPTION

Embodiments of the inventive subject matter described herein include electronic devices with RF reflectors that guide transmit and receive RF signals out of or into the device, while simultaneously shielding an electronic circuit from the electromagnetic radiation of the RF signals. The RF reflectors described herein may have the beneficial effect of reducing or substantially eliminating potential interference from the transmit and receive RF signals from impacting the operation or performance of the electronic circuit.

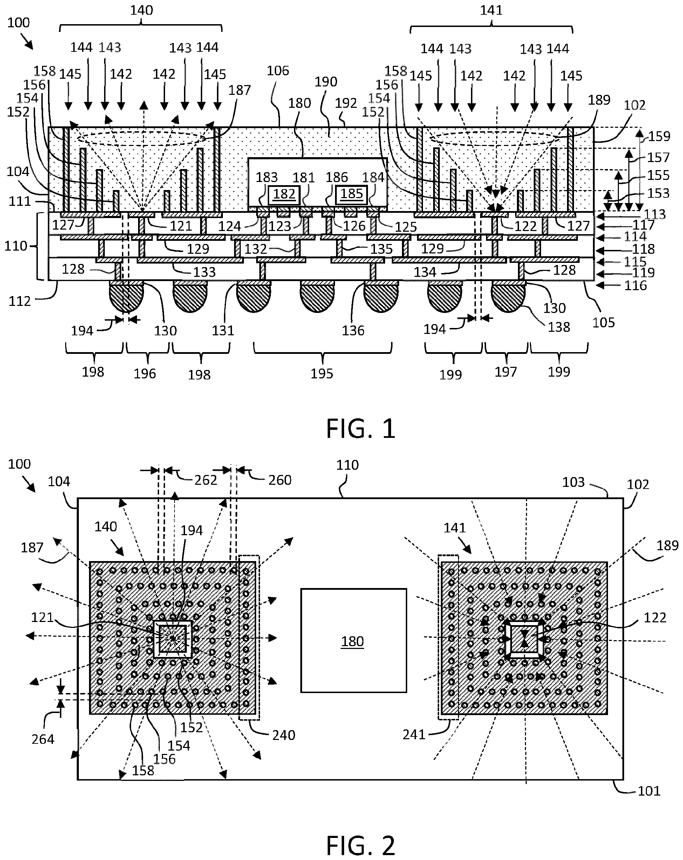

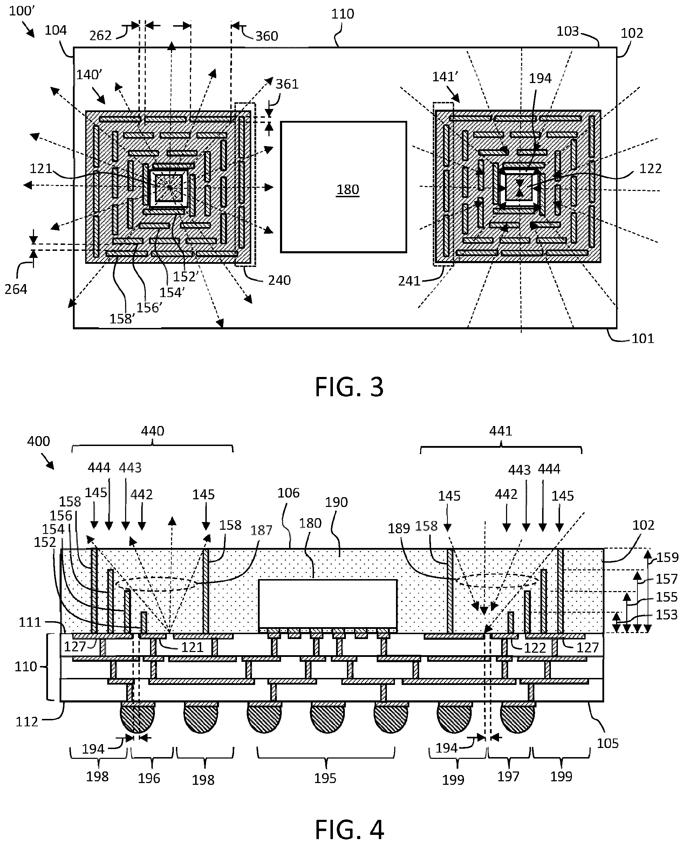

FIG. 1 is a side, cross-sectional view of an electronic device 100, according to one or more embodiments. To enhance understanding, FIG. 1 should be viewed simultaneously with FIGs 2 and 3, which are top views of two embodiments of the electronic device 100, 100' of FIG. 1. The primary difference between the embodiments of FIGs 2 and 3 is the shape of the to-be-described conductive vias 152, 152', 154, 154', 156, 156', 158, 158'. Accordingly, all details discussed in conjunction with device 100 of FIGs 1 and 2 apply also to device 100' of FIG. 3, except where differences are specifically noted.

According to one or more embodiments, the electronic device 100, 100' may be a discrete, surface-mountable device with first, second, third, and fourth sides 101, 102, 103, 104 that extend between a first device surface 105 (referred to herein as a "terminal surface") and a second device surface 106 (referred to herein as a "radiation surface"). The "radiation surface" 106 is so named because the device 100, 100' is configured to radiate and receive radio frequency (RF) signals 187, 189 through the radiation surface 106.

The "terminal surface" 105 is so named because a plurality of conductive device terminals (e.g., terminals 130, 131, 136) are exposed at the terminal surface 105, and these device terminals facilitate communication of electrical signals and voltages between circuitry within the device 100, 100' and external circuitry (not shown). Essentially, the device terminals at the terminal surface 112 are configured to enable integration of the device 100, 100' into a larger electrical system (e.g., a radar or communications system). More specifically, the device terminals at the terminal surface 105 may be aligned with corresponding terminals (not shown) on a system substrate (not shown), and the device terminals and the system substrate terminals may be physically and electrically connected using conductive attachment material (e.g., solder balls 138). Accordingly, device 100, 100' essentially is a surface-mountable, ball grid array (BGA) type of device. In other embodiments, a different type of electronic and mechanical interface may be used to connect the device 100, 100' to a system substrate (e.g., device 100, 100' may be a land grid array (LGA), a pin grid array (PGA) device, or have another type of interconnect structure).

By way of a brief summary, during system operation, the device 100, 100' is configured to transmit RF signals 187 through the radiation surface 106 using a first embedded antenna 121. The transmit RF signals 187 are indicated by arrows extending from antenna 121. Further, a second embedded antenna 122 of the device 100, 100' is configured to receive RF signals 189 that are conveyed through the radiation surface 106. The receive RF signals 189 are indicated by arrows extending to antenna 122. The transmit and receive RF signals 187, 189 may be processed by an embedded electronic circuit 180 (e.g., a transceiver circuit), as will be described in more detail below.

According to one or more embodiments, the electronic device 100, 100' includes first and second RF reflectors 140, 141 that at least partially surround the antennas 121, 122. The RF reflectors 140, 141 are configured to guide the transmit and receive RF signals 187, 189 out of or into the device 100, 100', while simultaneously shielding the electronic circuit 180 from the electromagnetic radiation of the RF signals 187, 189. Accordingly, potential interference from the transmit and receive RF signals 187, 189, which may otherwise affect the operation or performance of the electronic circuit 180, is reduced or substantially eliminated through the inclusion of the RF reflectors 140, 141.

Further, the device 100, 100' includes a routing structure 110 with first and second surfaces 111, 112 (referred to herein as a "mounting surface" and a "terminal surface", respectively). The routing structure 110 has first, second, third, and fourth sides (not numbered) that are co-planar with and which partially define the first, second, third, and fourth sides 101-104 of the device 100, 100'. The terminal surface 112 of the routing structure 110 defines the terminal surface 105 of the device 100, 100'.

According to one or more embodiments, the routing structure 110 includes a plurality of non-overlapping, laterally-abutting "zones," each of which extends between the mounting and terminal surfaces 111, 112 of the routing structure 110. These zones include a circuit zone 195, first and second antenna zones 196, 197, and first and second reflector zones 198, 199. As used herein and according to one or more embodiments, the term "non-overlapping," in the context of the routing structure zones 195-199, means that no portion of any particular zone overlies or underlies (in the orientation of FIG. 1) any portion of any other zone. In some embodiments, interconnect routing within the routing structure 110 between the electronic circuit 180 and other features of the device 100 may traverse into/through the reflector zones 198, 199 and/or the antenna zones 196, 197.

According to one or more embodiments, the electronic circuit 180 is coupled to mounting surface 111 of the routing structure 110 on and above the circuit zone 195 of the routing structure 110. The transmit and receive antennas 121, 122 are coupled to the routing structure 110 at or below the mounting surface 111 of the routing structure 110 in the first and second antenna zones 196, 197, respectively. Finally, the RF reflectors 140, 141 are coupled to the mounting surface 111 of the routing structure 110 on and above the first and second reflector zones 198, 199, respectively.

The routing structure 110 may, in various embodiments, take the form of a redistribution layer (RDL) structure, a multiple-layer printed circuit board (PCB) or another suitable structure. Regardless of the form it takes, the routing structure 110 includes multiple patterned conductive layers 113, 114, 115, 116 separated by multiple dielectric layers 117, 118, 119. Conductive vias (not numbered), may extend through the dielectric layers 117-119 to connect various sets of conductive features within adjacent conductive layers 113-116. Although four conductive layers 113-116 and three dielectric layers 117-119 are depicted in the drawings, alternate embodiments of a routing structure may include more or fewer conductive and dielectric layers.

According to some embodiments, a first patterned conductive layer 113 of the routing structure 110 includes a plurality of conductive features on or exposed at the mounting surface 111 of the routing structure 110. For example, the first patterned conductive layer 113 includes conductive features in the circuit zone 195 that correspond to conductive circuitry pads (e.g., pads 123, 124, 125, 126) to which the electronic circuit 180 is physically and electrically coupled, as will be described in more detail below.

According to one or more embodiments, the transmit and receive antennas 121, 122 also may be formed from portions of the first patterned conductive layer 113 in the first and second antenna zones 196, 197, respectively. The transmit and receive antennas 121, 122 may be patch antennas, in some embodiments, and accordingly may have square or rectangular planform shapes, as shown in FIG. 2. In alternate embodiments, the transmit and receive antennas 121, 122 may be other types of planar antennas. Either way, the transmit and receive antennas 121, 122 are integrally formed with or coupled to the routing structure 110 within the first and second antenna zones 196, 197, respectively. Although the transmit and receive antennas 121, 122 may be formed from conductive features of the first patterned conductive layer 113, in some embodiments, the transmit and receive antennas 121, 122 alternatively may be formed from conductive features that are not parts of the first patterned conductive layer 113, or they may be formed from portions of an underlying patterned conductive layer (e.g., from portions of layer 114).

According to one or more embodiments, the first patterned conductive layer 113 also includes conductive features in the first and second reflector zones 198, 199 that correspond to conductive ground pads 127 to which the first and second RF reflectors 140, 141 are physically and electrically coupled, as will also be described in more detail below. As best shown in FIG. 2, conductive ground pads 127 (and thus the first and second reflector zones 198, 199) may completely surround the first and second antenna zones 196, 197 (and thus completely surround the transmit and receive antennas 121, 122). In other embodiments, the conductive ground pads 127 (and thus the first and second reflector zones 198, 199) may only partially surround the first and second antenna zones 196, 197 (and thus may only partially surround the transmit and receive antennas 121, 122). Non-conductive gaps 194 electrically separate the conductive ground pads 127 from the transmit and receive antennas 121, 122 (i.e., the conductive ground pads 127 and the antennas 121, 122 are electrically isolated from each other). The non-conductive gaps 194 may extend all the way around the transmit and receive antennas 121, 122, as best shown in FIG. 2.

According to one or more embodiments, the second patterned conductive layer 114 includes planar conductive features positioned under and around the transmit and receive antennas 121, 122 (e.g., under the footprints of the conductive ground pads 127), and these conductive features function as planar RF signal reflectors 129 that prevent the electromagnetic energy emanating from or being received by the transmit and receive antennas 121, 122 from being conveyed toward the terminal surface 105 of the device 100, 100'. For example, the planar RF signal reflectors 129 may have a similar shape as the conductive ground pads 127, and may fully underly the conductive ground pads 127. As shown in FIG. 1, the planar RF signal reflectors 129 may have relatively small central openings that facilitate signal routing between the antennas 121, 122 and the electronic circuit 180.

The third patterned conductive layer 115 may function as a routing layer that facilitates electrical connection between the device terminals 130, 131, 136 at the terminal surface 105, the electronic circuit 180, the antennas 121, 122, and various grounded structures (e.g., the conductive ground pads 127 and the RF signal reflectors 129).

Finally, the fourth patterned conductive layer 116 may provide the above-mentioned conductive device terminals (e.g., terminals 130, 131, 136) at the terminal surface 112 of the routing structure 110 (and thus at the terminal surface 105 of the device 100, 100'). Some of the terminals 130 are configured to be coupled to ground (or to another voltage reference) of the larger electrical system. For example, according to one or more embodiments, the RF signal reflectors 129 and the conductive ground pads 127 (under the RF reflectors 140, 141) are electrically coupled through conductive routing paths 128 to the ground terminals 130 at the terminal surface 105 of the device 100, 100'. This enables the RF signal reflectors 129, the conductive ground pads 127, and the RF reflectors 140, 141 to be grounded during system operation.

Some other terminals 131, 136 at the terminal surface 105 are configured to be used as input/output (I/O) terminals for the electronic circuit 180. For example, terminal 131 may be configured as an input terminal of the device 100, 100', and terminal 136 may be configured as an output terminal of the device 100, 100'. Thus, terminals 131, 136 may be referred to herein as an input terminal 131 and an output terminal 136. Still other terminals (not numbered) at the terminal surface 105 may be used to convey control and/or bias signals to the electronic circuit 180.

As mentioned above, the electronic circuit 180 is coupled to mounting surface 111 of the routing structure 110 on and above the circuit zone 195 of the routing structure 110. More particularly, the electronic circuit 180 includes a plurality of terminals (e.g., first, second, third, and fourth terminals 181, 183, 184, 186), which are physically and electrically coupled to corresponding circuitry pads (e.g., first, second, third, and fourth circuitry pads 123, 124, 125, 126) at the mounting surface 111 of the routing structure 110. For example, as shown in FIG. 1, a first terminal 181 of the electronic circuit 180 is coupled to a first circuitry pad 123 of the routing structure 110. Similarly, a second circuitry pad 124 is coupled to a second terminal 183, a third circuitry pad 125 is coupled to a third terminal 184, and a fourth circuitry pad 126 is coupled to a fourth terminal 186.

According to an embodiment, the first circuitry pad 123 and the first terminal 181 of the electronic circuit 180 are electrically coupled through conductive routing path 132 to the input terminal 131 at the terminal surface 105 of the device 100, 100'. The second circuitry pad 124 and the second terminal 183 of the electronic circuit 180 are electrically coupled through conductive routing path 133 to the transmit antenna 121. The third circuitry pad 125 and the third terminal 184 of the electronic circuit 180 are electrically coupled through conductive routing path 134 to the receive antenna 122. Finally, the fourth circuitry pad 126 and the fourth terminal 186 of the electronic circuit 180 are electrically coupled through conductive routing path 135 to the output terminal 136 at the terminal surface 105 of the device 100, 100'.

The electronic circuit 180 is depicted in the drawings as an integrated circuit (IC) device that includes terminals (e.g., terminals 181, 183, 184, 186) that are coupled to corresponding conductive pads (e.g., pads 123, 124, 125, 126) at the mounting surface 111 of the routing structure 110. The IC device may be a flip-chip, ball grid array (BGA) device, in some embodiments, which includes transmitter circuitry 182 and receiver circuitry 185. In other embodiments, the electronic circuit 180 may be implemented with multiple ICs and/or discrete components, at least some of which are coupled to the mounting surface 111 of the routing structure 110. As shown in FIGs 1 and 2, the electronic circuit 180 may be coupled to the first surface 111 of the routing structure 110 between the transmit and receive antennas 121, 122 (and between the RF reflectors 140, 141). In other words, the circuit zone 195 of the routing structure 110 is between the first antenna/reflector zones 196/198 and the second antenna/reflector zones 197, 199. In other embodiments, the relative orientations of the electronic circuit 180, transmit and receive antennas 121, 122, and RF reflectors 140, 141 may be different (i.e., the orientations of the zones 195-199 of the routing structure 110 may be different).

According to one or more embodiments, and as indicated above, the electronic circuit 180 may be a transceiver circuit that includes transmitter circuitry 182 and receiver circuitry 185. The terminals 181, 183, 184, 186 of the electronic circuit 180 are electrically coupled to the transmitter and receiver circuitry 182, 185. For example, the first terminal 181 may function as an input terminal to the transmitter circuitry 182, and the first terminal 181 may be electrically coupled through the first circuitry pad 123 and conductive routing path 132 to the input terminal 131 of the device 100, 100'. During device operation, an input signal is conveyed from the input terminal 131 through the conductive path 132 to the first circuitry pad 123 and the first terminal 181, and the transmitter circuitry 182 may process (e.g., amplify) the input signal, and provide a processed (e.g., amplified) version of the signal to the second terminal 183. This signal, in turn, may be conveyed from the second circuitry pad 124 and conductive routing path 133 to the transmit antenna 121, which then radiates the signal over the air as the transmit RF signal 187.

Conversely, during device operation, a receive RF signal 189 may impinge upon the receive antenna 122. The receive antenna 122 may convert the receive RF signal 189 to an electrical signal that is conveyed from the receive antenna 122 through the conductive routing path 134 to the third circuitry pad 125 and the third terminal 184 of the electronic circuit 180. The receiver circuitry 185 may then process (e.g., filter and amplify) the signal, and may provide a processed (e.g., filtered and amplified) version of the signal to the fourth terminal 186. This signal, in turn, may be conveyed from the fourth circuitry pad 126 and the conductive routing path 135 to the output terminal 136 of the device 100, 100'.

According to one or more embodiments, the electronic device 100, 100' also includes encapsulant 190 overlying the transmit and receive antennas 121, 122, the electronic circuit 180, the RF reflectors 140, 141, and the mounting surface 111 of the routing structure 110. An upper surface 192 of the encapsulant 190 defines the radiation surface 106 of the device 100, 100'. Further, the encapsulant 190 has first, second, third, and fourth sides (not numbered) that are co-planar with and which partially define the first, second, third, and fourth sides 101-104 of the device 100, 100'.

The first and second RF reflectors 140, 141 of FIGs 1 and 2 will now be described in more detail, along with describing alternate embodiments of the first and second RF reflectors 140', 141' in a modified electronic device 100' illustrated in FIG. 3. As mentioned above, the first and second RF reflectors 140, 140', 141, 141' are configured to guide the transmit and receive RF signals 187, 189 out of or into the device 100, 100', while simultaneously shielding the electronic circuit 180. According to one or more embodiments, the first and second RF reflectors 140, 140', 141, 141' are coupled to the mounting surface 111 of the routing structure 110 above the first and second reflector zones 198, 199, respectively. For example, the lowest extents of each of the first and second RF reflectors 140, 140', 141, 141' (i.e., proximal ends of vias 152, 152', 154, 154', 156, 156', 158, 158') may be physically connected to the conductive ground pads 127 in each of the first and second reflector zones 198, 199. During operation of device 100, 100', this enables the first and second RF reflectors 140, 140', 141, 141' to be electrically grounded. Further, each of the first and second RF reflectors 140, 140', 141, 141' may extend from its lowest extent at the mounting surface 111 to or toward the radiation surface 106 of the device 100, 100'.

The first and second RF reflectors 140, 140', 141, 141' may have various configurations, as will be explained below. Generally, various embodiments of each of the first and second RF reflectors 140, 140', 141, 141' described herein include an inner boundary portion and an outer boundary portion. Each inner boundary portion is defined as the part of the RF reflector 140, 140', 141, 141' that is adjacent to (and closest to) a respective antenna zone 196, 197 (and a respective antenna 121, 122), and each outer boundary portion is defined as the part of the RF reflector 140, 140', 141, 141' that is farthest from a respective antenna zone 196, 197 (and a respective antenna 121, 122). In other words, each inner boundary portion corresponds to a portion of the RF reflector 140, 140', 141, 141' that defines an inner perimeter of the RF reflector 140, 140', 141, 141', and each outer boundary portion corresponds to a portion of the RF reflector 140, 140', 141, 141' that defines an outer perimeter of the RF reflector 140, 140', 141, 141'.

According to one or more embodiments, the inner boundary portion of each RF reflector 140, 140', 141, 141' extends substantially perpendicularly from the mounting surface 111 to a first height 153 above the mounting surface 111. Further, the outer boundary portion of each RF reflector 140, 140', 141, 141' extends substantially perpendicularly from the mounting surface 111 to a second height 159 above the mounting surface 111, where the second height 159 is greater than the first height 153. According to some embodiments, the first height 153 above the mounting surface 111 is in the range of about 10 percent to about 80 percent of the second height 159 above the mounting surface 111, although the relative heights 153, 159 may be different from the above-given range, as well.

In the embodiments illustrated in FIGs 2 and 3, and according to one or more embodiments, each RF reflector 140, 140', 141, 141' may include or consist of multiple concentric "rings" 142, 143, 144, 145 of conductive vias 152, 154, 156, 158 (FIG. 2) or 152', 154', 156', 158' (FIG. 3). According to one or more embodiments, each of the concentric rings 142, 143, 144, 145 is separated from adjacent concentric rings 142, 143, 144, 145 by an inter-ring spacing 264. For example, the inter-ring spacing 264 may be less than lambda/8, where lambda equals the wavelength of the fundamental frequency of operation of the device 100 (or the wavelength of the highest frequency within the band in which the device 100 operates). For example, the inter-ring spacing 264 may be in a range of about lambda/16 to about lambda/8, although the inter-ring spacing 264 may be smaller or larger, as well.

The conductive vias 152, 152' of the inner ring 142 extend from their proximal ends at the mounting surface 111 to their distal ends at the first height 153 above the mounting surface 111 (i.e., to the height 153 of the inner boundary portion). The inner ring 142 of conductive vias 152, 152' defines the inner boundary portion of each RF reflector 140, 140', 141, 141'. Accordingly, the inner ring 142 (and the inner boundary portion) is the closest portion of the RF reflector 140, 140', 141, 141' to the antenna 121, 122. Each inner ring 142 is "adjacent to" its respective antenna 121, 122 in that no conductive features are present between each inner ring 142 and its respective antenna 121, 122. The vias 152, 152' of the inner ring 142 may substantially or completely surround each antenna zone 196, 197 and antenna 121, 122 on all sides, as shown in FIGs 2 and 3. Alternatively, as will be discussed later in conjunction with FIGs 4-6, the vias 152, 152' of each inner ring 142 may only partially surround each antenna zone 196, 197 and antenna 121, 122.

The conductive vias 158, 158' of the outer ring 145 extend from their proximal ends at the mounting surface 111 to their distal ends at the second height 159 above the mounting surface 111 (i.e., to a height 159 of the outer boundary portion). The outer ring 145 of conductive vias 158, 158' defines the outer boundary portion of each RF reflector 140, 140', 141, 141'. The vias 158 of each outer ring 145 may substantially or completely surround an inner ring 142 of vias 152, and accordingly may substantially or completely surround the antenna zone 196, 197 and the antenna 121, 122 on all sides, as shown in FIGs 2 and 3. Alternatively, the vias 158 of each outer ring 145 may only partially surround the antenna zone 196, 197 and antenna 121, 122.

Importantly, each outer ring 145 has a circuit-adjacent segment (e.g., segments 240, 241, FIGs 2, 3) that includes multiple adjacent conductive vias 158, 158' that are positioned directly between the antenna 121, 122 and the electronic circuit 180 (i.e., between the antenna zones 196, 197 and the circuit zone 195). According to one or more embodiments, the heights 159 of the conductive vias 158, 158' within each circuit-adjacent segment 240, 241 are at least as high as the height (not numbered) of the electronic circuit 180 (or at least those components of the electronic circuit 180 that are susceptible to electromagnetic interference). Further, in some embodiments, the heights 159 of the conductive vias 158, 158' within each circuit-adjacent segment 240, 241 of the outer ring 145 may be about equal to the height (not numbered) of the encapsulant 190. In other embodiments, the heights 159 of the conductive vias 158, 158' within each circuit-adjacent segment 240, 241 of the outer ring 145 may be less than the height of the encapsulant 190, although not significantly less to avoid the phenomenon of signal energy from the transmit RF signal 187 reflecting downward from the radiation surface 106 through the space between the radiation surface 106 and the tops of the conductive vias 158 in the circuit-adjacent segment 240, 241. For example, the maximum difference in the heights of the encapsulant 190 and the vias 158 in segment 240, 241 may be selected dependent on the bandwidth or frequency of operation of the device 100, 100' (e.g., the maximum difference in height may be less than lambda/8, where lambda is the wavelength associated with the frequency of operation of the device 100, 100' or the lower bandwidth limit).

As can be seen most clearly in FIG. 1, the heights 153, 155, 157, 159 of the conductive vias 152, 152', 154, 154', 156, 156', 158, 158' within the rings 142-145 increase from the inner ring 142 to the outer ring 145. Said another way, the heights 153, 155, 157, 159 of the conductive vias 152, 152', 154, 154', 156, 156', 158, 158' in each concentric ring 142, 143, 144, 145 increase the farther the ring 142, 143, 144, 145 is from the associated antenna 121, 122. Accordingly, each of the RF reflectors 140, 140', 141, 141' may be considered to have an upwardly and outwardly extending upper boundary, where the upper boundary may be defined as an imaginary surface that intersects the distal ends of the conductive vias 152, 152', 154, 154', 156, 156', 158, 158' that form each RF reflector 140, 140', 141, 141'. Said another way, the upper extent of each of the RF reflectors 140, 140', 141, 141' extends upwardly and outwardly from the inner ring 142 to the outer ring 145. As best indicated in FIG. 1, this configuration defines a radiation space for the transmit and receive signals 187, 189 that has an inverted, 3-dimensional, cone-shaped area, with the "point" of the cone shape corresponding to the location of the antenna 121, 122.

In the embodiment of FIG. 2, each conductive via 152, 154, 156, 158 has a substantially circular cross-sectional shape. Accordingly, a height (e.g., height 153, 155, 157, 159) of each via 152, 154, 156, 158 is significantly greater (e.g., from 5 to 50 times greater) than its diameter (e.g., diameter 260, FIG. 2). For example, but not by way of limitation, each conductive via 152, 154, 156, 158 may have a height 153, 155, 157, 159 in a range of about 20 microns to about 2000 microns. In other embodiments, the heights 153, 155, 157, 159 may be smaller or larger than the above-given range. Further, the diameter 260 of each via 152, 154, 156, 158 may be in a range of about 20 microns to about 200 microns, although the diameter 260 may be smaller or larger, as well.

Conversely, in the embodiment of device 100' illustrated in FIG. 3, each conductive via 152', 154', 156', 158' has a "bar" cross-sectional shape. According to some embodiments, the cross-sectional length 360 of each via 152', 154', 156', 158' is substantially greater (e.g., from 2 to 20 times greater) than the cross-sectional width 361 of each via 152', 154', 156', 158'. For example, the cross-sectional length 360 of each via 152', 154', 156', 158' may be in a range of about 40 microns to about 2000 microns, and the cross-sectional width 361 of each via 152', 154', 156', 158' may be in a range of about 20 microns to about 200 microns, although the width 361 and/or length 360 may be smaller or larger, as well. Further, a height (e.g., height 153, 155, 157, 159) of each via 152', 154', 156', 158' is significantly greater (e.g., from 5 to 50 times greater) than the cross-sectional width 361 of each via 152', 154', 156', 158'.

Adjacent vias 152, 152', 154, 154', 156, 156', 158, 158' within each ring of vias 142-145 are separated from each other by an inter-via spacing 262. For example, the inter-via spacing 262 may be in a range of about 100 microns to about 1000 microns, although the inter-via spacing 262 may be smaller or larger, as well. The inter-via spacing 262 may be selected based on the frequency or bandwidth of operation of the device 100, 100'. More particularly, the inter-via spacing 262 may be selected to block signal energy from the transmit and receive RF signals 187, 189 from traveling from the interior to the exterior of each ring 142, 143, 144, 145. For example, the selected inter-via spacing 262 may be less than lambda/8, where lambda is the wavelength associated with the frequency of operation of the device 100, 100' or the lower bandwidth limit.

In this manner, signal energy from the transmit and receive RF signals 187, 189 is constrained within the inverted cone-shaped area defined by each RF reflector 140, 140', 141, 141'. This has the beneficial effect of focusing the signal energy in a direction that extends from each antenna 121, 122 through the radiation surface 106 of the device 100, 100', and not laterally through the sides of the encapsulant 190. In addition, this has the further beneficial effect of shielding the electronic circuit 180 from the signal energy of the transmit and receive RF signals 187, 189. As mentioned previously, reducing or substantially eliminating potential interference from the transmit and receive RF signals 187, 189 may reduce or eliminate negative interference effects on the operation and performance of the electronic circuit 180.

In the embodiment illustrated in FIGs 1-3, each RF reflector 140, 140', 141, 141' is shown to include four concentric rings 142, 143, 144, 145 of conductive vias 152, 152', 154, 154', 156, 156', 158, 158', although other embodiments may include as few as two concentric rings (e.g., an inner and outer ring), or more than four concentric rings. Each ring 142, 143, 144, 145 includes a plurality of conductive vias 152, 152', 154, 154', 156, 156', 158, 158' aligned along the boundaries of the ring shape (e.g., a rectangular shape, as shown in FIGs 2 and 3, although the ring shape alternatively may be circular or otherwise polygonal). In some embodiments, the heights (e.g., heights 153, 155, 157, 159) of the conductive vias 152, 152', 154, 154', 156, 156', 158, 158' in any given ring 142, 143, 144, 145 may be substantially the same (e.g., the heights 153 of the vias 142, 142' in ring 152 are the same as each other, and the heights 155 of the vias 154, 154' in ring 143 are the same as each other but higher than the vias 152, 152' in ring 142, and so on).

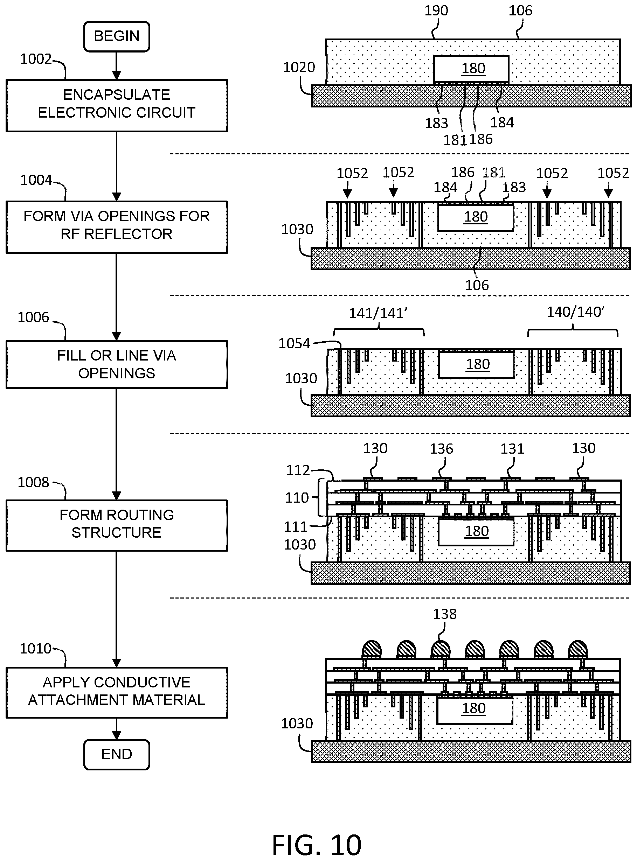

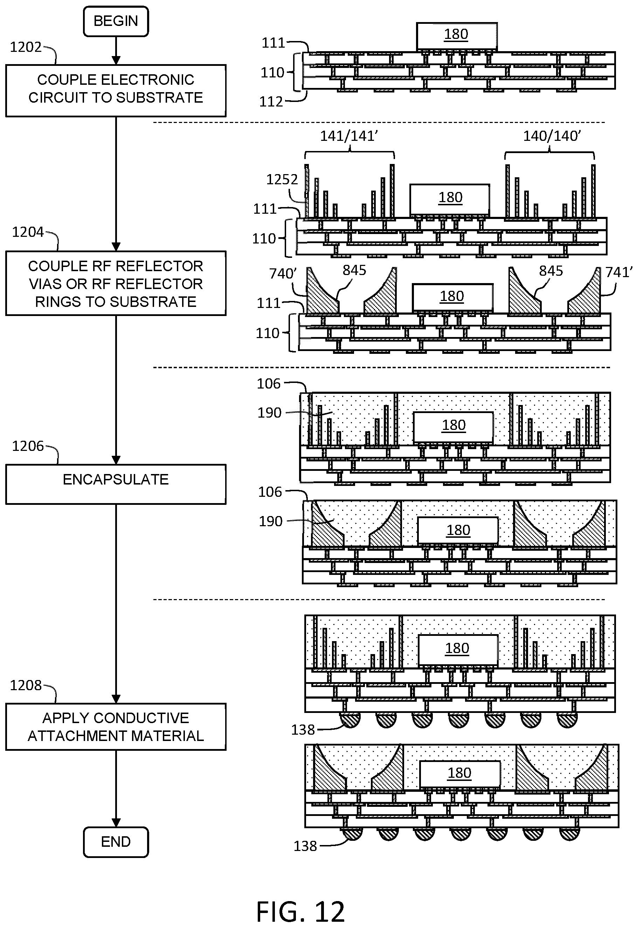

As will be described in more detail later in conjunction with FIG. 10, in various embodiments, each conductive via 152, 152', 154, 154', 156, 156', 158, 158' may consist of an elongated hole (e.g., opening 1052, FIG. 10) in the encapsulant 190 that is lined or completely filled with conductive material (e.g., conductive material 1054, FIG. 10). Conversely, as will be described in more detail later in conjunction with FIG. 12, each conductive via 152, 152', 154, 154', 156, 156', 158, 158' may include a conductive pillar (e.g., pillar 1252, FIG. 12) that is built up upon or attached to the mounting surface 111 of the routing structure 110 (and more specifically to a ground pad 127) before the encapsulant 190 is applied over the mounting surface 111 of the routing structure 110.

The embodiments of electronic device 100, 100' discussed in conjunction with FIGs 1-3 each include RF reflectors 140, 140', 141, 141' with multiple concentric rings 142-145 of conductive vias 152, 152', 154, 154', 156, 156', 158, 158', where each ring 142-145 completely surrounds its respective antenna 121, 122. As indicated previously, in some alternate embodiments, at least some of the rings may only partially surround an antenna 121, 122.

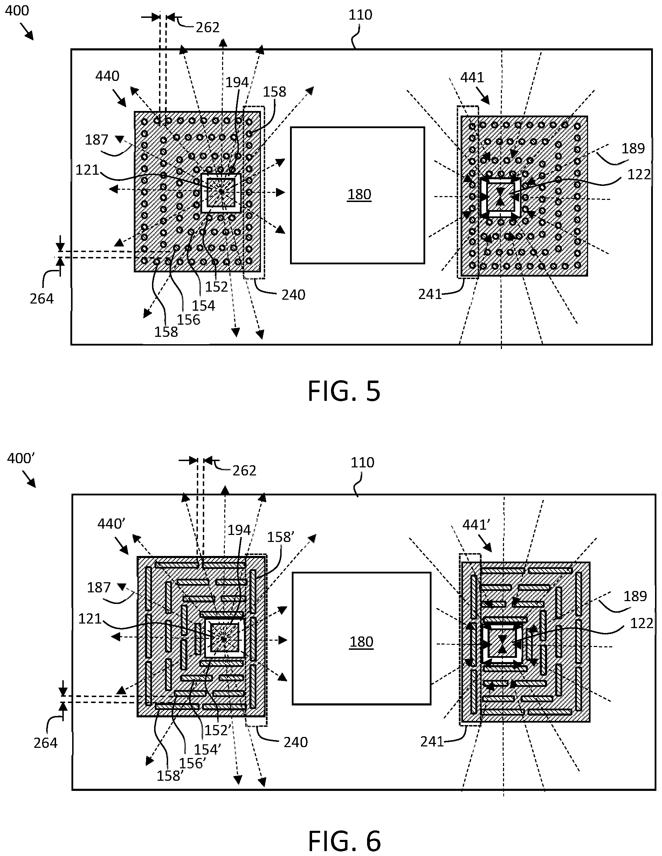

For example, FIG. 4 is a side, cross-sectional view of an alternate embodiment of an electronic device 400, according to one or more embodiments. To enhance understanding, FIG. 4 should be viewed simultaneously with FIGs 5 and 6, which are top views of two embodiments of the electronic device 400, 400' of FIG. 4. As will be explained in more detail below, the primary difference between device 400, 400' and device 100, 100' is that, in device 400, 400', several of the rings 442, 443, 444 of conductive vias 152, 152', 154, 154', 156, 156' only partially surround their respective antennas 121, 122. Note that in FIGs 4-6 and the corresponding description, below, when the same reference numbers are used to identify various elements as were used in FIGs 1-3 and their corresponding description, the details and various embodiments discussed above with respect to such elements is hereby incorporated into the below description of FIGs 4-6. For purposes of brevity, all details are not repeated below.

As with device 100, 100', the electronic device 400, 400' may be a discrete, surface-mountable device with a terminal surface 105 and a radiation surface 106. Further, the device 400 includes a routing structure 110 with mounting and terminal surfaces 111, 112, where the terminal surface 112 of the routing structure 110 defines the terminal surface 105 of the device 400, 400'. A plurality of conductive device terminals (e.g., terminals 130, 131, 136, FIG. 1) are exposed at the terminal surface 105, 112. These terminals are electrically connected through various conductive paths (e.g., paths 128, 132, 135, FIG. 1) to electronic circuit 180 (and to the transmitter and receiver circuitry 182, 185, FIG. 1), and to ground pads 127 and RF reflectors 129. Further, the electronic circuit 180 is electrically connected through additional conductive paths (e.g., paths 133, 134, FIG. 1) to first and second antennas 121, 122. Further still, the electronic device 400, 400' also includes encapsulant 190 overlying the transmit and receive antennas 121, 122, the electronic circuit 180, the RF reflectors 440, 440', 441, 441' and the mounting surface 111 of the routing structure 110. An upper surface 192 of the encapsulant 190 defines the radiation surface 106 of the device 400, 400'.

The routing structure 110 also includes the above-described circuit zone 195, first and second antenna zones 196, 197, and first and second reflector zones 198, 199. According to one or more embodiments, the electronic circuit 180 is coupled to mounting surface 111 of the routing structure 110 on and above the circuit zone 195. The transmit and receive antennas 121, 122 are coupled to the routing structure 110 at or below the mounting surface 111 in the first and second antenna zones 196, 197, respectively.

According to one or more embodiments, the electronic device 400, 400' also includes first and second RF reflectors 440, 440', 441, 441' that at least partially surround the antennas 121, 122. Again, the first and second RF reflectors 440, 440', 441, 441' are configured to guide transmit and receive RF signals 187, 189 out of or into the device 400, 400', while simultaneously shielding the electronic circuit 180.

The RF reflectors 440, 440', 441, 441' are coupled to the mounting surface 111 of the routing structure 110 on and above the first and second reflector zones 198, 199, respectively. For example, the lowest extents of each of the first and second RF reflectors 440, 440', 441, 441' (i.e., proximal ends of vias 152, 152', 154, 154', 156, 156', 158, 158') may be physically connected to the conductive ground pads 127 in each of the first and second reflector zones 198, 199. Non-conductive gaps 194 electrically separate the conductive ground pads 127 from the transmit and receive antennas 121, 122. Further, each of the first and second RF reflectors 440, 440', 441, 441' may extend from its lowest extent at the mounting surface 111 to or toward the radiation surface 106 of the device 400, 400'. Further still, each of the first and second RF reflectors 440, 440', 441, 441' include an inner boundary portion and an outer boundary portion. Each inner boundary portion is defined as a part of the RF reflector 440, 440', 441, 441' that is adjacent to (and closest to) a respective antenna zone 196, 197 (and a respective antenna 121, 122), and each outer boundary portion is defined as a part of the RF reflector 440, 440', 441, 441' that is farthest from a respective antenna zone 196, 197 (and a respective antenna 121, 122).

The first and second RF reflectors 440, 440', 441, 441' of FIGs 4-6 differ from the RF reflectors 140, 140', 141, 141' of FIGs 1-3, and those differences will now be described in more detail. Primarily, each of the rings 142-145 of vias 152, 152', 154, 154', 156, 156', 158, 158' in the devices 100, 100' of FIGs 1-3 completely surround their respective antennas 121, 122. However, this is not the case for the RF reflectors 440, 440', 441, 441' of devices 400, 400' (FIGs 4-6).

According to one or more embodiments, the inner boundary portion of each RF reflector 440, 440', 441, 441' extends substantially perpendicularly from the mounting surface 111, and at least part of the inner boundary portion extends to a first height 153 above the mounting surface 111. Further, the outer boundary portion of each RF reflector 440, 440', 441, 441' extends substantially perpendicularly from the mounting surface 111 to a second height 159 above the mounting surface 111, where the second height 159 is greater than the first height 153. According to some embodiments, the first height 153 above the mounting surface 111 is in the range of about 10 percent to about 80 percent of the second height 159 above the mounting surface 111, although the relative heights 153, 159 may be different from the above-given range, as well.

In the embodiments illustrated in FIGs 5 and 6, and according to one or more embodiments, each RF reflector 440, 440', 441, 441' may include or consist of one or more complete rings of conductive vias (e.g., ring 145 of vias 158 (FIG. 5) or 158' (FIG. 6)), and one or more partial rings of conductive vias (e.g., partial rings 442, 443, 444 of vias 152, 154, 156 (FIG. 5) or 152', 154', 156' (FIG. 6)). As best seen in FIGs 5 and 6, partial rings 442, 443, 444 surround three sides of their respective antennas 121, 122. However, these partial rings 442, 443, 444 do not include circuit-adjacent segments (i.e., segments that extend between the antennas 121, 122 and the electronic circuit 180). In contrast, complete rings 145 completely surround their respective antennas 121, 122, and each includes a circuit-adjacent segment 240, 241 that includes multiple adjacent conductive vias 158, 158' that are positioned directly between the antenna 121, 122 and the electronic circuit 180 (i.e., between the antenna zones 196, 197 and the circuit zone 195).

The conductive vias 152, 152' of the inner ring 442 extend from their proximal ends at the mounting surface 111 to their distal ends at the first height 153 above the mounting surface 111. The conductive vias 158, 158' of the complete outer ring 145 extend from their proximal ends at the mounting surface 111 to their distal ends at the second height 159 above the mounting surface 111 (i.e., to a height 159 of the outer boundary portion). The conductive vias 154, 154', 156, 156' of the intermediate rings 443, 444 have upper extents at heights 155, 157 between the first and second heights 153, 159.

Similar to the devices 100, 100' of FIGs 1-3, in devices 400, 400', the outer ring 145 of conductive vias 158, 158' defines the outer boundary portion of each RF reflector 440, 440', 441, 441'. The vias 158 of each outer ring 145 may substantially or completely surround the inner and intermediate partial rings 442, 443, 444 of vias 152, 154, 156, and accordingly may substantially or completely surround the antenna zone 196, 197 and the antenna 121, 122 on all sides, as shown in FIGs 5 and 6.

Because the inner ring 442 lacks a circuit-adjacent segment, the inner boundary portion of each RF reflector 440, 440', 441, 441' is defined on three sides by the vias 152 of the inner ring 442, and on the fourth side by the vias 158 of the circuit-adjacent segments 240, 241 of the outer ring 145. Accordingly, the inner boundary portion of each RF reflector 440, 440', 441, 441' varies in height from the height 153 of the vias 152 of the inner ring 442 to the height 159 of the vias 158 of the circuit-adjacent segment 240, 241 of the outer ring 145. Because the height 159 of the vias 158, 158' in the circuit-adjacent segments 240, 241 may extend to (or nearly to) the radiation surface 106, these circuit-adjacent segments 240, 241 may function to reduce or substantially eliminate potential interference from the transmit and receive RF signals 187, 189, which otherwise may negatively affect the operation and performance of the electronic circuit 180.

Similar to the embodiment of FIG. 2, in the embodiment of device 400 illustrated in FIG. 5, each conductive via 152, 154, 156, 158 has a substantially circular cross-sectional shape. Conversely, in the embodiment of device 400' illustrated in FIG. 6 (and similar to the embodiment of FIG. 3), each conductive via 152', 154', 156', 158' has a "bar" cross-sectional shape.

As with the previously-described embodiments, each of the concentric rings 442, 443, 444, 145 is separated from adjacent concentric rings 442, 443, 444, 145 by an inter-ring spacing 264. Further, adjacent vias 152, 152', 154, 154', 156, 156', 158, 158' within each ring of vias 442, 443, 444, 145 are separated from each other by an inter-via spacing 262. Again, the inter-via spacing 262 may be selected to block signal energy from the transmit and receive RF signals 187, 189 from traveling from the interior to the exterior of each ring 442, 443, 444, 145. In this manner, signal energy from the transmit and receive RF signals 187, 189 is constrained within the inverted partial cone-shaped area defined by each RF reflector 440, 440', 441, 441'. Similar to the previously-described embodiments, this has the beneficial effect of focusing the signal energy in a direction that extends from each antenna 121, 122 through the radiation surface 106 of the device 400, 400', and not laterally through the sides of the encapsulant 190. In addition, this has the further beneficial effect of shielding the electronic circuit 180 from the signal energy of the transmit and receive RF signals 187, 189.

The embodiments of electronic devices 100, 100', 400, 400' discussed in conjunction with FIGs 1-6 each include RF reflectors 140, 140', 141, 141', 440, 440', 441, 441' with multiple, concentric, complete or partial rings 142-145, 442-444 of conductive vias 152, 152', 154, 154', 156, 156', 158, 158'. In one or more alternate embodiments, the RF reflectors may be formed from conductive structures other than sets of conductive vias.

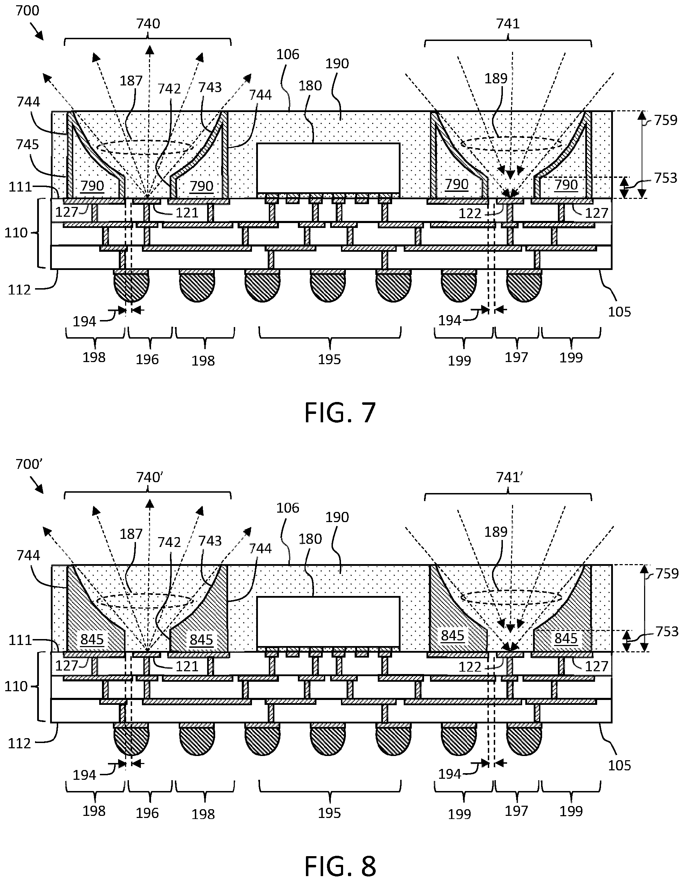

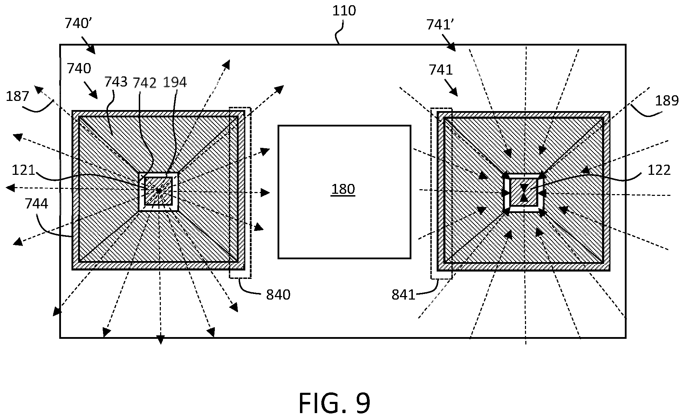

For example, FIGs 7 and 8 are side, cross-sectional views of two alternate embodiments of electronic devices 700, 700', according to one or more embodiments. To enhance understanding, FIGs 7 and 8 should be viewed simultaneously with FIG. 9, which is a top view of an embodiment of the electronic devices 700, 700' of FIGs 7 and 8. As will be explained in more detail below, the primary difference between devices 700, 700' and devices 100, 100', 400, 400' is that, in devices 700, 700', each RF reflector 740, 740', 741, 741' is defined by one or more solid conductive surfaces 742, 743, 744, rather than being defined by conductive vias. Note that, in FIGs 7-9 and the corresponding description, below, when the same reference numbers are used to identify various elements as were used in FIGs 1-6 and their corresponding description, the details and various embodiments discussed above with respect to such elements is hereby incorporated into the below description of FIGs 7-9. For purposes of brevity, all details are not repeated below.

As with devices 100, 100', 400, 400', the electronic devices 700, 700' may be discrete, surface-mountable devices, each with a terminal surface 105 and a radiation surface 106. Further, each device 700, 700' includes a routing structure 110 with mounting and terminal surfaces 111, 112, where the terminal surface 112 of the routing structure 110 defines the terminal surface 105 of the device 700, 700'. A plurality of conductive device terminals (e.g., terminals 130, 131, 136, FIG. 1) are exposed at the terminal surface 105, 112. These terminals are electrically connected through various conductive paths (e.g., paths 128, 132, 135, FIG. 1) to electronic circuit 180 (and to the transmitter and receiver circuitry 182, 185, FIG. 1), and to ground pads 127 and RF reflectors 129. Further, the electronic circuit 180 is electrically connected through additional conductive paths (e.g., paths 133, 134, FIG. 1) to first and second antennas 121, 122. Further still, each electronic device 700, 700' also includes encapsulant 190 overlying the transmit and receive antennas 121, 122, the electronic circuit 180, the RF reflectors 740, 740', 741, 741' and the mounting surface 111 of the routing structure 110. An upper surface 192 of the encapsulant 190 defines the radiation surface 106 of the device 700, 700'.

The routing structure 110 also includes the above-described circuit zone 195, first and second antenna zones 196, 197, and first and second reflector zones 198, 199. According to one or more embodiments, the electronic circuit 180 is coupled to mounting surface 111 of the routing structure 110 on and above the circuit zone 195. The transmit and receive antennas 121, 122 are coupled to the routing structure 110 at or below the mounting surface 111 in the first and second antenna zones 196, 197, respectively.

According to one or more embodiments, each electronic device 700, 700' also includes first and second RF reflectors 740, 740', 741, 741' that at least partially surround the antennas 121, 122 (and the antenna zones 196, 197). Again, the first and second RF reflectors 740, 740', 741, 741' are configured to guide transmit and receive RF signals 187, 189 out of or into the device 700, 700', while simultaneously shielding the electronic circuit 180.

The RF reflectors 740, 740', 741, 741' are coupled to the mounting surface 111 of the routing structure 110 on and above the first and second reflector zones 198, 199, respectively. For example, the lowest extents of each of the first and second RF reflectors 740, 740', 741, 741' may be physically connected to the conductive ground pads 127 in each of the first and second reflector zones 198, 199. Non-conductive gaps 194 electrically separate the conductive ground pads 127 from the transmit and receive antennas 121, 122. Further, each of the first and second RF reflectors 740, 740', 741, 741' may extend from its lowest extent at the mounting surface 111 to or toward the radiation surface 106 of the device 700, 700'. Further still, each of the first and second RF reflectors 740, 740', 741, 741' include an inner boundary portion and an outer boundary portion. Each inner boundary portion is defined as the part of the RF reflector 740, 740', 741, 741' that is adjacent to (and closest to) a respective antenna zone 196, 197 (and a respective antenna 121, 122), and each outer boundary portion is defined as the part of the RF reflector 740, 740', 741, 741' that is farthest from a respective antenna zone 196, 197 (and a respective antenna 121, 122).

As mentioned above, the first and second RF reflectors 740, 741 of FIGs 7-9 differ from the RF reflectors 140, 140', 141, 141', 440, 440', 441, 441' of FIGs 1-6, and those differences will now be described in more detail. Primarily, each of the RF reflectors 740, 740', 741, 741' of devices 700, 700' are defined by one or more solid conductive surfaces 742, 743, 744, rather than being defined by conductive vias. In some embodiments, such as those shown in FIGs 7 and 8, each of the RF reflectors 740, 740', 741, 741' includes an inner conductive surface 742 that corresponds to the inner boundary portion of the RF reflector 740, 740', 741, 741', an outer conductive surface 744 that corresponds to the outer boundary portion of the RF reflector 740, 740', 741, 741', and an intermediate conductive surface 743 that extends from the upper extent of the inner conductive surface 742 to the upper extent of the outer conductive surface 744. In other words, the intermediate conductive surface 743 extends from the first height 753 at the inner boundary portion to the second height 759 at the outer boundary portion.

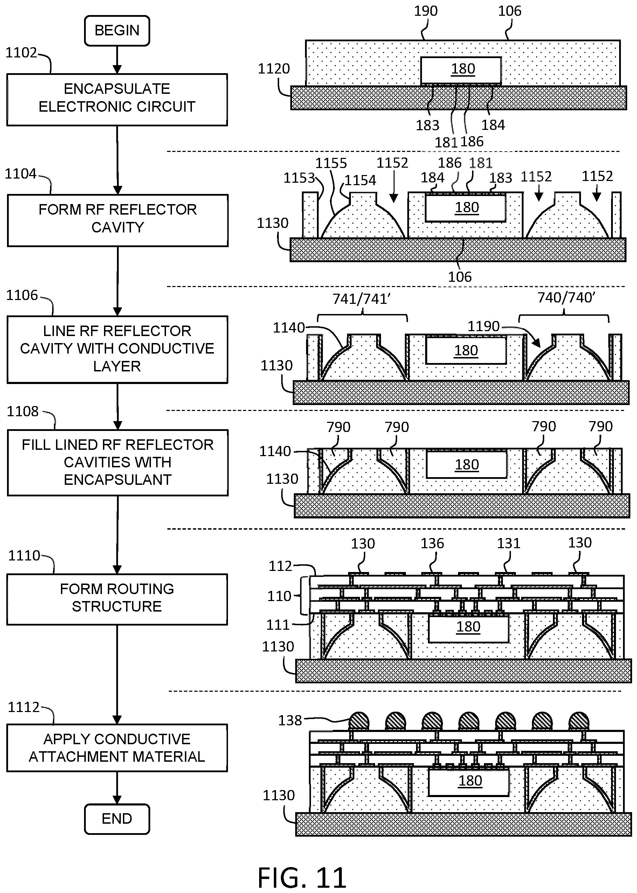

In the embodiment of device 700 illustrated in FIG. 7, the inner, intermediate, and outer conductive surfaces 742-744 of each of the RF reflectors 740, 741 are formed from a layer of conductive material (e.g., layer 1140, FIG. 11). In such embodiments, the cavity (e.g., cavity 1190, FIG. 11) that otherwise would be present underneath the RF reflectors 740, 741 may be filled with non-conductive encapsulant material 790, in some embodiments. In other embodiments, the cavity may remain unfilled (i.e., it is an air cavity), or the cavity may be filled with conductive material (not illustrated).

In the embodiment of device 700' illustrated in FIG. 8, each of the RF reflectors 740', 741' are formed from a solid conductive body 845, and thus the inner, intermediate, and outer conductive surfaces 742-744 of the RF reflectors 740', 741' correspond to the outer surfaces of the solid conductive bodies 845.

Either way, according to one or more embodiments, the inner boundary portion of each RF reflector 740, 740', 741, 741' is defined by the inner conductive surface 742, which may extend substantially perpendicularly from the mounting surface 111 to a first height 753 above the mounting surface 111. For example, but not by way of limitation, the first height 753 may be in a range of 10 microns to about 1000 microns, although the first height 753 may be smaller or larger, as well. According to one or more embodiments, the inner conductive surface 742 may extend all the way around and thus fully surround each antenna 121, 122. According to other embodiments, the inner conductive surface 742 (and by extension, the intermediate and outer conductive surfaces 743, 744) may extend only partially around each antenna 121, 122.

According to some alternate embodiments of devices 700, 700', the height 753 of the perpendicularly-extending inner conductive surface 742 may be reduced to a minimum value (e.g., close to zero mm), so that the inner perimeter of the intermediate conductive surface 743 starts essentially at the mounting surface 111 of the routing structure 110. In such embodiments, the inner boundary portion essentially corresponds to the inner perimeter of the intermediate conductive surface 743.

The outer boundary portion of each RF reflector 740, 740', 741, 741' may be defined by the outer conductive surface 744, which may extend substantially perpendicularly from the mounting surface 111 to a second height 759 above the mounting surface 111, where the second height 759 is greater than the first height 753. For example, but not by way of limitation, the second height 759 may be in a range of 20 microns to about 2000 microns, although the second height 759 may be larger, as well. According to some embodiments, the first height 753 above the mounting surface 111 is in the range of about 10 percent to about 80 percent of the second height 759 above the mounting surface 111, although the relative heights 753, 759 may be different from the above-given range, as well.

In additional alternate embodiments of device 700 (FIG. 7), the outer conductive surface 744 may be excluded from the RF reflectors 740, 741 by eliminating the portion of the conductive layer (e.g., conductive layer 1140, FIG. 11) that corresponds to the outer conductive surface 744. In such embodiments, the outer boundary portion of the RF reflector essentially corresponds to the outer perimeter of the intermediate conductive surface 743, and accordingly, the outer boundary portion is separated from the mounting surface 111 of the routing structure 110 by the second height 759.

As mentioned above, the intermediate conductive surface 743 extends from the upper extent of the inner conductive surface 742 to the upper extent of the outer conductive surface 744. More specifically, because height 759 is larger than height 753, the intermediate conductive surface 743 extends from the upper extent of the inner conductive surface 742 upwardly and outwardly to the upper extent of the outer conductive surface 744. Accordingly, the intermediate conductive surface 743 essentially may resemble a conductive bowl (with a central opening) that fully or partially surrounds each antenna 121, 122 (i.e., the antennas 121, 122 are positioned within or below the central opening). The shape of the interior surface of the conductive bowl may be concave, as shown in FIGs 7 and 8, or alternatively may be flat (i.e., extending linearly from the upper extent of the inner conductive surface 742 to the upper extent of the outer conductive surface 744).

As shown in FIG. 8, the outer conductive surface 744 and/or the outer perimeter of each intermediate conductive surface 743 has a circuit-adjacent segment 840, 841 that is positioned directly between the antenna 121, 122 and the electronic circuit 180 (i.e., between the antenna zones 196, 197 and the circuit zone 195). According to one or more embodiments, the height 159 of the outer conductive surface 744 (or the height 159 of the outer perimeter of the intermediate conductive surface 743) for each circuit-adjacent segment 840, 841 is at least as high as the height (not numbered) of the electronic circuit 180 (or at least those components of the electronic circuit 180 that are susceptible to electromagnetic interference). Further, in some embodiments, the height 159 may be about equal to the height (not numbered) of the encapsulant 190. In other embodiments, the height 159 may be less than the height of the encapsulant 190, although not significantly less to avoid the phenomenon of signal energy from the transmit RF signal 187 reflecting downward from the radiation surface 106 through the space between the radiation surface 106 and the tops of the circuit-adjacent segments 840, 841 (i.e., the maximum difference in the heights of the encapsulant 190 and the circuit-adjacent segments 840, 841 is dependent on the bandwidth or frequency of operation of the device 700, 700').

According to various embodiments, signal energy from the transmit and receive RF signals 187, 189 is constrained within the bowl-shaped area defined by each RF reflector 740, 740', 741, 741'. Similar to the previously-described embodiments, this has the beneficial effect of focusing the signal energy in a direction that extends from each antenna 121, 122 through the radiation surface 106 of the device 700, 700', and not laterally through the sides of the encapsulant 190. In addition, this has the further beneficial effect of shielding the electronic circuit 180 from the signal energy of the transmit and receive RF signals 187, 189.

In the embodiments of devices 100, 100', 400, 400', 700, 700' shown in FIGs 1-9, the electronic circuit 180 (and circuit zone 195) is positioned between a transmit antenna 121 (and antenna zone 196) and a receive antenna 122 (and antenna zone 197). In alternate embodiments, the electronic circuit 180, transmit antenna 121, and receive antenna 122 may have a different relative arrangement.

Further, although the illustrated embodiments of devices 100, 100', 400, 400', 700, 700' each include one instance of transmitter circuitry 182 coupled to a single transmit antenna 121, and one instance of receiver circuitry 185 coupled to a single receive antenna 122, other embodiments may include only one instance of either the transmitter or receiver circuitry 182, 185, and accordingly only one of either the transmit antenna 121 or the receive antenna 122. In still other embodiments, a device may include multiple transmit antennas 121 and/or multiple receive antennas 122, which may enable multiple-input, multiple-output (MIMO) operation.

Embodiments of methods for fabricating the above-described embodiments of devices 100, 100', 400, 400', 700, 700' will now be described. It should be mentioned here that devices 100, 100', 400, 400', 700, 700' may be fabricated individually. More likely, however, multiple instances of the devices 100, 100', 400, 400', 700, 700' may be fabricated simultaneously in a strip or panel form, where the individual devices 100, 100', 400, 400', 700, 700' are separated from the strip or panel during a later fabrication step. For ease of illustration, FIGs 10-12 depict devices that are formed individually.

Starting first with the embodiments depicted in FIGs 1-6, FIG. 10 is a flowchart of a method for fabricating the electronic devices 100, 100', 400, 400' (FIGs 1-6), in accordance with an example embodiment. For enhanced understanding, small depictions of the partially formed devices during the various fabrication stages are shown to the right of each corresponding flowchart block.

The method begins, in block 1002, by temporarily coupling an electronic circuit 180 to a carrier 1020 so that the terminals of the electronic circuit 180 (e.g., terminals 181, 183, 184, 186, FIG. 1) face and contact the carrier 1020. Although the electronic circuit 180 is shown as a single IC, it should be understood that the electronic circuit 180 may include multiple discrete components.

The electronic circuit 180 is then encapsulated by applying encapsulant 190 over the electronic circuit 180 and over the upper surface of the carrier 1020. The height of the encapsulant 190 should be sufficient to cover the electronic circuit 180. In various embodiments, the encapsulant 190 may include one or more epoxy molding compounds (EMC) or other suitable materials, which may be molded (e.g., compression or injection molded) or dispensed (e.g., screen printed) over the electronic circuit 180 and the upper surface of the carrier 1020. Unless a subsequent grinding or polishing process is performed to thin the encapsulant 190, the upper surface of the encapsulant 190 corresponds to the radiation surface 106 of the partially-formed device.

In block 1004, the partially-fabricated device may be removed from the carrier 1020, flipped upside-down, and coupled to another carrier 1030 so that the radiation surface 106 of the partially-formed device is facing the carrier 1030, and a surface of the encapsulant 190 opposite the radiation surface 106 is facing upward, and the terminals 181, 183, 184, 186 of the electronic circuit 180 are exposed. Multiple concentric rings of via openings 1052 are then formed through the upper surface of the encapsulant 190 in the locations where the conductive vias (e.g., vias 152, 152', 154, 154', 156, 156', 158, 158', FIGs 1-6) are to be located (i.e., in portions of the encapsulant 190 adjacent to the sides of the electronic circuit 180). For example, the via openings 1052 may be formed using laser drilling or other suitable techniques. The depths of the via openings within each concentric ring may be controlled through control of the energy and/or time associated with the laser drilling process. The depths of the via openings correspond to the ultimate heights (e.g., heights 153, 155, 157, 159, FIGs 1, 4) of the to-be-formed vias. For the tallest to-be-formed vias (e.g., vias 158, FIGs 1-6), the via openings may be drilled all the way through the radiation surface 106 to the carrier 1030, although these via openings may stop short of the radiation surface 106, as well. Further, the cross-sectional shapes of the via openings 1052 correspond of the shapes of the to-be-formed vias (e.g., the cross-sectional shapes of the via openings 1052 may be substantially circular for vias 152, 154, 156, 158, and the cross-sectional shapes of the via openings 1052 may be bar-shaped for vias 152', 154', 156', 158').

In block 1006, electrically conductive material 1054 then may be applied in the via openings 1052 in order to form the vias (e.g., vias 152, 152', 154, 154', 156, 156', 158, 158', FIGs 1-6). For example, the vias may be plated with copper or another conductive metal, or the vias may be filled with electrically conductive epoxy or another conductive material (e.g., metal). This completes the formation of the RF reflectors 140, 140', 141, 141' (FIGs 1-6).

In block 1008, the routing structure 110 is then built up on the exposed surface of the encapsulant 190. For example, the routing structure 110 may be formed as an RDL structure using appropriate techniques. For example, in one or more embodiments, forming the routing structure 110 may include forming a first patterned conductive layer (e.g., layer 113, FIGs 1, 4) over the exposed surfaces of the encapsulant 190, the electronic circuit 180, and the proximal ends of the vias. For example, the first patterned conductive layer may include circuitry pads 123-126 in contact with the terminals (e.g., terminals 181, 183, 184, 186) of the electronic circuit 180, ground pads 127 in contact with proximal ends of the vias (and thus in contact with the RF reflectors 140, 140', 141, 141'), and the antennas 121, 122 (although in other embodiments, the antennas 121, 122 may be located in a subsequently-formed conductive layer). A first dielectric layer (e.g., layer 117, FIGs 1, 4) then may be formed over the first patterned conductive layer, and openings may be formed through the first dielectric layer to expose the circuitry pads 123-126, the ground pads 127, and the antennas 121, 122. The first dielectric layer and the first patterned conductive layer define the mounting surface 111 of the routing structure 110. An iterative process of forming subsequent patterned conductive layers (e.g., layers 114-116) interleaved with subsequent dielectric layers (e.g., layers 118, 119) may then be performed to complete formation of the routing structure 110. Upon completion, a plurality of conductive device terminals (e.g., terminals 130, 131, 136) are exposed at the terminal surface 112 of the routing structure 110.

In block 1010, conductive attachment material (e.g., solder balls 138) then may be applied to the device terminals, and the device may be removed from the carrier 1030. At this stage, formation of the device 100, 100', 400, 400' is complete. When the device has been formed in a strip or panel with other devices (not shown), a device singulation process may be performed to separate the devices into discrete units. The method may then end.

Moving now to the embodiments depicted in FIGs 7-9, FIG. 11 is a flowchart of a method for fabricating the electronic devices 700, 700' (FIGs 7-9), in accordance with an example embodiment. The method begins, in block 1102, by temporarily coupling an electronic circuit 180 to a carrier 1120 so that the terminals of the electronic circuit 180 (e.g., terminals 181, 183, 184, 186, FIG. 1) face and contact the carrier 1120. Although the electronic circuit 180 is shown as a single IC, it should be understood that the electronic circuit 180 may include multiple discrete components.

The electronic circuit 180 is then encapsulated by applying encapsulant 190 over the electronic circuit 180 and over the upper surface of the carrier 1120. The height of the encapsulant 190 should be sufficient to cover the electronic circuit 180. In various embodiments, the encapsulant 190 may include one or more EMC or other suitable materials, which may be molded (e.g., compression or injection molded) or dispensed (e.g., screen printed) over the electronic circuit 180 and the upper surface of the carrier 1120. Unless a subsequent grinding or polishing process is performed to thin the encapsulant 190, the upper surface of the encapsulant 190 corresponds to the radiation surface 116 of the partially-formed device.

In block 1104, the partially-fabricated device may be removed from the carrier 1120, flipped upside-down, and coupled to another carrier 1130 so that the radiation surface 106 of the partially-formed device is facing the carrier 1130. RF reflector cavities 1152 are then formed through the upper surface of the encapsulant 190 in the locations where the RF reflectors (e.g., RF reflectors 740, 740', 741, 741', FIGs 7-9) are to be located. For example, the RF reflector cavities 1152 may be formed using mechanical drilling, laser drilling or other suitable techniques. The shapes of the RF reflector cavities 1152 correspond to the ultimate shapes (e.g., the bowl shape) of the to-be-formed RF reflectors 740, 740', 741, 741'. More specifically, the shape of each RF reflector cavity 1152 may be defined by an inner perimeter encapsulant sidewall 1154 that extends from the surface of encapsulant 190 to a first depth (corresponding to the first height 753, FIG. 7), an outer perimeter encapsulant sidewall 1153 that extends from the surface of encapsulant 190 to a second, deeper depth (corresponding to second height 759, FIG. 7), and a transitional sidewall 1155 that extends from the deepest extent of the outer perimeter encapsulant sidewall 1153 to the deepest extent of the inner perimeter encapsulant sidewall 1154. The deepest extent of the outer perimeter encapsulant sidewall 1153 may extend through the radiation surface 106 to the carrier 1130, although the outer perimeter encapsulant sidewall 1153 may stop short of the radiation surface 106, as well.

In block 1106, an electrically conductive material layer 1140 then may be applied in the RF reflector cavities 1152 in order to form the RF reflectors 740, 740', 741, 741'. For example, surfaces of the encapsulant 190 where the layer 1140 is not to be applied may be masked, and the material of layer 1140 then may be sputtered or otherwise deposited at least on the transitional sidewall 1155 of the reflector cavity, and possibly on all of the sidewalls 1153-1155 of the RF reflector cavities 1152. For example, the layer 1140 may be formed from copper or another suitable metal. The layer 1140 may have a thickness in a range of about 3 microns to about 30 microns, although layer 1140 may be thinner or thicker, as well. Application of layer 1140 results in the formation of lined cavities 1190, and the surfaces of the layers 1140 that contact the sidewalls 1153-1155 define the RF reflectors 740, 740', 741, 741' (FIGs 7-9).

In block 1108, the lined cavities 1190 are filled with non-conductive encapsulant material 790, according to one or more embodiments. In other embodiments, the cavities 1190 may remain unfilled (i.e., as air cavities), or the cavities 1190 may be filled with conductive material (not illustrated).

In block 1110, the routing structure 110 is then built up on the exposed surface of the encapsulant 190, 790. For example, as discussed above in conjunction with block 1008 of FIG. 10, the routing structure 110 may be formed as an RDL structure using appropriate techniques. The above details regarding forming the routing structure 110 apply equally to the description of block 1110, and those details are incorporated here.

In block 1112, conductive attachment material (e.g., solder balls 138) then may be applied to the device terminals (e.g., terminals 130, 131, 136), and the device may be removed from the carrier 1130. At this stage, formation of the device 700, 700' is complete. When the device has been formed in a strip or panel with other devices (not shown), a device singulation process may be performed to separate the devices into discrete units. The method may then end.

The fabrication methods described in conjunction with FIGs 10 and 11 include forming the routing structure 110 as an RDL structure. In other embodiments, the routing structure 110 may include a multiple-layer PCB or other suitable substrate. Devices 100, 100', 400, 400', and 700' may be fabricated using an RDL structure, as shown in FIGs 10 and 11 and described above, or these devices 100, 100', 400, 400', and 700' may be fabricated using a multiple-layer PCB, as shown in FIG. 12 and described below.

More specifically, FIG. 12 is a flowchart of a method for fabricating the electronic devices 100, 100', 400, 400', and 700' (FIGs 1-6 and 8), in accordance with other example embodiments. For enhanced understanding, small depictions of partially formed devices during the various fabrication stages are shown to the right of each corresponding flowchart block. For some of the fabrication stages, partially formed devices are shown that include RF reflectors formed from both vias and solid conductive rings.

The method begins, in block 1202, by mounting an electronic circuit 180 to the mounting surface 111 of a routing structure 110. According to an embodiment, the routing structure 110 may be a multi-layer PCB, which includes multiple patterned conductive layers (e.g., layers 113-116, FIGs 1, 4) separated by multiple dielectric layers (e.g., layers 117-119, FIGs 1, 4). Conductive vias (not numbered), may extend through the dielectric layers 117-119 to connect various sets of conductive features within adjacent conductive layers 113-116. A first patterned conductive layer (e.g., layer 113) of the routing structure 110 may include a plurality of conductive features on or exposed at the mounting surface 111 of the routing structure 110. For example, the first patterned conductive layer may include conductive features that correspond to conductive circuitry pads (e.g., pads 123, 124, 125, 126), and corresponding terminals (e.g., terminals 181, 183, 184, 186) of the electronic circuit 180 are physically and electrically coupled to those circuitry pads. For example, the circuitry pads and device terminals may be coupled together using solder, electrically conductive adhesive, or other suitable materials.

In block 1204, RF reflectors (e.g., reflectors 140, 140', 141, 141' or 740', 741') are then formed on or coupled to the mounting surface 111 of the routing structure 110. According to some embodiments, and as shown in the upper image next to block 1204, conductive posts 1252 (corresponding to vias 152, 154, 156, 158, FIGs 1, 4) are connected to or built up on the ground pads 127 in the RF reflector zones (e.g., zones 198, 199, FIGs 1-6). According to other embodiments, and as shown in the lower image next to block 1204, a ring-shaped, solid conductive body 845 (FIG. 8) may be connected to or built up on the ground pads 127 in the RF reflector zones (e.g., zones 198, 199, FIG. 8). For example, the conductive posts 1252 or the solid conductive body 845 may be formed from copper or other electrically-conductive materials.

In block 1206, the electronic circuit 180 and the RF reflectors 140, 140', 141, 141', 740', 741' are then encapsulated by applying encapsulant 190 over the electronic circuit 180, over the RF reflectors 140, 140', 141, 141', 740', 741', and over the mounting surface 111 of the routing structure 110. The height of the encapsulant 190 should be sufficient to cover the electronic circuit 180 and the RF reflectors 140, 140', 141, 141', 740', 741'. In various embodiments, the encapsulant 190 may include one or more EMC or other suitable materials, which may be molded (e.g., compression or injection molded) or dispensed (e.g., screen printed) over the electronic circuit 180, the RF reflectors 140, 140', 141, 141', 740', 741', and the mounting surface 111. Unless a subsequent grinding or polishing process is performed to thin the encapsulant 190, the upper surface of the encapsulant 190 corresponds to the radiation surface 106 of the partially-formed device.

In block 1208, conductive attachment material (e.g., solder balls 138) then may be applied to the device terminals (e.g., terminals 130, 131, 136). At this stage, formation of the device 100, 100', 400, 400', 700' is complete. When the device has been formed in a strip or panel with other devices (not shown), a device singulation process may be performed to separate the devices into discrete units. The method may then end.

An embodiment of an electronic device includes a routing structure, an electronic circuit, a first antenna, and a first RF reflector. The routing structure has a first surface, a mounting surface opposite the first surface, a circuit zone extending between the first surface and the mounting surface, a first antenna zone extending between the first surface and the mounting surface, and a first reflector zone extending between the first surface and the mounting surface. The electronic circuit is coupled to the mounting surface of the routing structure above the circuit zone. The first antenna is coupled to the routing structure in the first antenna zone and is electrically coupled to the electronic circuit. The first RF reflector is coupled to the mounting surface above the first reflector zone. The first RF reflector includes an inner boundary portion that is adjacent to the first antenna zone, and a circuit-adjacent segment positioned between the inner boundary portion and the electronic circuit. At least part of an upper extent of the inner boundary portion is at a first height above the mounting surface. An upper extent of the circuit-adjacent segment is at a second height above the mounting surface that is greater than the first height.

According to a further embodiment, the first RF reflector includes an inner ring of conductive vias that at least partially surrounds the first antenna zone and that defines the inner boundary portion, and an outer ring of conductive vias that at least partially surrounds the inner ring of conductive vias, where the circuit-adjacent segment of the first RF reflector includes a portion of the outer ring of conductive vias located between the inner ring and the circuit zone.

According to a further embodiment, the first RF reflector includes a first conductive surface that extends upwardly and outwardly from the first height to the second height. In some embodiments, a conductive layer defines the first conductive surface. In other embodiments, a solid conductive body defines the first conductive surface.

According to a further embodiment, the routing structure also includes a second antenna zone extending between the first surface and the mounting surface, and a second reflector zone extending between the first surface and the mounting surface. In such an embodiment, the electronic device further includes a second antenna coupled to the routing structure in the second antenna zone and electrically coupled to the electronic circuit, and a second RF reflector coupled to the mounting surface of the routing structure above the second reflector zone.

An embodiment of a method of fabricating an electronic device includes providing a routing structure that has a first surface, a mounting surface opposite the first surface, a circuit zone extending between the first surface and the mounting surface, an antenna zone extending between the first surface and the mounting surface, and an RF reflector zone extending between the first surface and the mounting surface, and an antenna in the antenna zone. The method further includes coupling an electronic circuit to the mounting surface of the routing structure over the circuit zone, where the routing structure electrically couples the electronic circuit to the antenna, and coupling an RF reflector to the mounting surface of the routing structure over the RF reflector zone. The RF reflector includes an inner boundary portion that is adjacent to the antenna zone, and a circuit-adjacent segment positioned between the inner boundary portion and the electronic circuit. At least part of an upper extent of the inner boundary portion is at a first height above the mounting surface. An upper extent of the circuit-adjacent segment is at a second height above the mounting surface that is greater than the first height.

According to a further embodiment, the routing structure is a printed circuit board, coupling the electronic circuit to the routing structure includes mounting the electronic circuit to the printed circuit board, and coupling the RF reflector to the routing structure includes forming the RF reflector on or coupling the RF reflector to the printed circuit board.

According to another further embodiment, the method further includes applying encapsulant over the electronic circuit, where a first surface of the encapsulant defines a radiation surface of the electronic device, forming via openings in a second surface of the encapsulant, and applying electrically conductive material in the via openings to form conductive vias that define the RF reflector.

According to another further embodiment, the method further includes applying encapsulant over the electronic circuit, where a first surface of the encapsulant defines a radiation surface of the electronic device, and forming a cavity in a second surface of the encapsulant, where the cavity is defined by an inner perimeter encapsulant sidewall that extends from the second surface of encapsulant to first depth corresponding to the first height, an outer perimeter encapsulant sidewall that extends from the second surface of the encapsulant to a second depth corresponding to the second height, and a transitional sidewall that extends from a deepest extent of the outer perimeter encapsulant sidewall to a deepest extent of the inner perimeter encapsulant sidewall. The method further includes forming the RF reflector by applying a layer of conductive material at least on the transitional sidewall.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

The foregoing description refers to elements or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. An electronic device comprising:
a routing structure with a first surface, a mounting surface opposite the first surface, a circuit zone extending between the first surface and the mounting surface, a first antenna zone extending between the first surface and the mounting surface, and a first reflector zone extending between the first surface and the mounting surface;
an electronic circuit coupled to the mounting surface of the routing structure above the circuit zone;
a first antenna coupled to the routing structure in the first antenna zone and electrically coupled to the electronic circuit; and
a first radio frequency, RF, reflector coupled to the mounting surface above the first reflector zone, wherein the first RF reflector includes
an inner boundary portion that is adjacent to the first antenna zone, wherein at least part of an upper extent of the inner boundary portion is at a first height above the mounting surface, and
a circuit-adjacent segment positioned between the inner boundary portion and the electronic circuit, wherein an upper extent of the circuit-adjacent segment is at a second height above the mounting surface that is greater than the first height.

2. The electronic device of claim 1, further comprising:
encapsulant overlying the mounting surface of the routing structure, the electronic circuit, and the first RF reflector, wherein the encapsulant defines a radiation surface of the electronic device.

3. The electronic circuit of claim 2, wherein:
the second height is equal to a height of the encapsulant.

4. The electronic device of any preceding claim, wherein:
the first height is in a range of 10 percent to 80 percent of the second height.

5. The electronic device of any preceding claim, wherein:
the routing structure further includes a ground pad at the mounting surface, wherein the first RF reflector is coupled to the ground pad; and
the first antenna is electrically separated from the ground pad by a non-conductive gap.

6. The electronic device of claim 5, wherein:
the ground pad and the first antenna are formed from portions of one or more patterned conductive layers of the routing structure.

7. The electronic device of any preceding claim, wherein the first RF reflector comprises:
an inner ring of conductive vias that at least partially surrounds the first antenna zone and that defines the inner boundary portion; and
an outer ring of conductive vias that at least partially surrounds the inner ring of conductive vias, wherein the circuit-adjacent segment of the first RF reflector includes a portion of the outer ring of conductive vias located between the inner ring and the circuit zone.

8. The electronic device of claim 7, wherein the first RF reflector further comprises:
one or more intermediate rings of conductive vias between the inner and outer rings of conductive vias, wherein upper extents of the one or more intermediate rings are at heights between the first and second heights.

9. The electronic device of any preceding claim, wherein the first RF reflector comprises:
a first conductive surface that extends upwardly and outwardly from the first height to the second height.

10. The electronic device of claim 9, wherein the first RF reflector comprises:
a conductive layer that defines the first conductive surface.

11. The electronic device of claim 9, wherein the first RF reflector comprises:
a solid conductive body that defines the first conductive surface.

12. The electronic device of any preceding claim, wherein:
the routing structure further includes a second antenna zone extending between the first surface and the mounting surface, and a second reflector zone extending between the first surface and the mounting surface; and
the electronic device further includes
a second antenna coupled to the routing structure in the second antenna zone and electrically coupled to the electronic circuit, and
a second RF reflector coupled to the mounting surface of the routing structure above the second reflector zone.

13. The electronic device of claim 12, wherein:
the electronic circuit includes a transmitter circuitry an a receiver circuitry, the first antenna is electrically coupled to the transmitter circuitry, and the second antenna is electrically coupled to the receiver circuitry.

14. A method of fabricating an electronic device, the method comprising:
providing a routing structure that has a first surface, a mounting surface opposite the first surface, a circuit zone extending between the first surface and the mounting surface, an antenna zone extending between the first surface and the mounting surface, and a radio frequency, RF, reflector zone extending between the first surface and the mounting surface, and an antenna in the antenna zone;
coupling an electronic circuit to the mounting surface of the routing structure over the circuit zone, wherein the routing structure electrically couples the electronic circuit to the antenna; and
coupling an RF reflector to the mounting surface of the routing structure over the RF reflector zone, wherein the RF reflector includes
an inner boundary portion that is adjacent to the antenna zone, wherein at least part of an upper extent of the inner boundary portion is at a first height above the mounting surface, and
a circuit-adjacent segment positioned between the inner boundary portion and the electronic circuit, wherein an upper extent of the circuit-adjacent segment is at a second height above the mounting surface that is greater than the first height.

15. The method of claim 14, wherein:
the routing structure is a printed circuit board;
coupling the electronic circuit to the routing structure includes mounting the electronic circuit to the printed circuit board; and
coupling the RF reflector to the routing structure includes forming the RF reflector on or coupling the RF reflector to the printed circuit board.
